# FASCICULE DE BREVET EUROPEEN

(11) **EP 1 884 149 B1**
(45) Date de publication et mention de la délivrance du brevet: **14.08.2013**
(21) Numéro de dépôt: 06754807.3
(22) Date de dépôt: 24.04.2006
(51) Int. Cl.: H05K 7/20

(54) **DISPOSITIF ELECTRONIQUE MODULAIRE FONCTIONNANT DANS DES ENVIRONNEMENTS SEVERES**
IN SCHWIERIGEN UMGEBUNGEN ARBEITENDE MODULARE ELEKTRONISCHE VORRICHTUNG
MODULAR ELECTRONIC DEVICE OPERATING IN DIFFICULT ENVIRONMENTS

(30) Priorité: 24.05.2005 FR 0505210
(43) Date de publication de la demande: 06.02.2008
(73) Titulaire: THALES, 92200 Neuilly sur Seine (FR)
(72) Inventeur: NEMOZ, Gérard, F-94700 Maisons-alfort (FR); LEBORGNE, Olivier, F-78890 Garancieres (FR); BERNADAC, Serge, F-92220 Bagneux (FR)
(74) Mandataire: Esselin, Sophie
(86) Numéro de dépôt international: PCT/EP2006/061780
(87) Numéro de publication internationale: WO 2006/125704

(56) Documents cités:
- DE-U1- 29 923 011
- FR-A- 2 826 831
- US-A- 5 201 855
- US-A- 6 084 774
- US-B1- 6 466 441

## Description

L'invention se rapporte à un dispositif électronique fonctionnant dans des environnements sévères.

L'invention trouve une utilité particulière en aéronautique et notamment à bord d'aéronefs de petites dimensions et non pressurisés, en particulier les hélicoptères, ne bénéficiant pas d'un environnement climatique protégé garanti par leur structure ou leur fonction de climatisation. Un tel environnement climatique protégé est nécessaire au fonctionnement des équipements électroniques, par exemple des cartes de circuits imprimés, montés à bord des aéronefs. En effet, un mouvement forcé de fluide caloporteur, tel que par exemple de l'air, à proximité d'équipements électroniques sert à évacuer la chaleur que les équipements électroniques dissipent. La durée de vie de ces équipements électroniques est dégradée si le fluide caloporteur en circulation est porteur d'impuretés par exemple corrosives. Il est donc nécessaire d'assurer une circulation de fluide caloporteur à proximité des équipements électroniques tout en évitant un contact direct entre le fluide et les équipements électroniques.

Une solution à ce problème consiste à rendre étanche au fluide caloporteur un boîtier d'appareillage électronique dans lequel sont montés des cartes de circuits imprimés. Un inconvénient présenté par cette solution vient de ce que l'évacuation hors du boîtier de la chaleur dissipée par les composants électroniques portés par les cartes de circuits imprimés, n'est alors pas toujours suffisante ou bien est réalisable uniquement au prix d'un alourdissement significatif du boîtier causé par l'emploi de drains thermiques pour conduire la chaleur dissipée par des cartes de circuits imprimés jusqu'aux parois du boîtier.

US6084774 B1 décrit un dispositif électronique qui compose une carte de circuits imprimés supportant des composants électroniques dissipant de la chaleur, un radiateur dont une première face est en contact avec des composants électroniques et dont une deuxième face est conformée pour évacuer la chaleur par convection. Un fluide caloporteur assurant la convection de la chaleur du radiateur et des composants électroniques,

FR1828831 A1 décrit un dispositif de refroidissement d'au moins un module électronique de puissance, par exemple pour un véhicule automobile, du type comprenant une enceinte de circulation d'un fluide caloporteur fixée sur ledit module et comportant une entrée et une sortie dudit fluide, ou l'enceinte comprend, d'une part, des parois latérales déterminant un cadre et, d'autre part, deux fonds dont au moins un est formé par une semelle dudit module, la paroi latérale et lesdits fonds ménageant un circuit pour ledit fluide caloporteur.

Un but important de l'invention est donc de pallier cet inconvénient.

Pour atteindre ce but, l'invention propose un dispositif électronique comportant un boîtier d'appareillage électronique configuré pour loger un ou une pluralité de sous-ensembles électroniques enfichables, chaque sous-ensemble électronique comprenant
- une carte de circuits imprimés supportant des composants électroniques dissipant de la chaleur,
- un radiateur dont une première face est en contact avec des composants électroniques d'une première face de la carte de circuits imprimés et dont une deuxième face est conformée pour évacuer la chaleur par convection,
caractérisé en ce que le sous-ensemble comporte également :
- un capot solidaire du radiateur et de la carte de circuits imprimés, délimitant un canal entre la deuxième face du radiateur et le capot, pour la circulation d'un fluide caloporteur assurant la convection, des joints déformables assurant l'étanchéité du canal,
ledit canal évitant au fluide caloporteur d'être en contact avec les composants électroniques.

Par rapport à l'état de l'art présenté plus haut, l'invention présente un triple avantage :
- son efficacité en terme de dissipation thermique est renforcée ;
- sa modularité contribue à une réduction de la masse des calculateurs ;
- sa compatibilité avec les standards connus de boîtiers aéronautiques connus facilite les phases de conception.

Le capot de chaque sous-ensemble électronique assure à la fois une fonction de canalisation du flux caloporteur pour la carte électronique qu'il comporte, et une fonction d'isolation de ce flux vis-à-vis des composants situés sur la deuxième face d'une carte électronique d'un sous-ensemble électronique adjacent.

La surface d'échange thermique avec un fluide caloporteur extérieur au boîtier est directement liée à la carte de circuits intégrés, au plus près des sources de chaleur qu'il faut évacuer. L'invention permet donc d'éviter l'emploi d'un drain thermique pour évacuer la chaleur hors du boîtier, ce qui est très favorable sur le plan du bilan thermique. Ceci est d'autant plus vrai que le nombre de cartes de circuits intégrés équipant le boîtier est élevé, car la surface d'échange thermique est proportionnelle au nombre de cartes de circuits intégrés utilisés. D'autre part, le recours à un drain thermique couvrant la totalité possible de la dissipation, pouvant être lourd et/ou volumineux, n'est pas toujours favorable sur le plan du bilan de masse et de volume. C'est le cas par exemple lorsque le boîtier est équipé d'une unique carte de circuits intégrés.

Selon une caractéristique de l'invention, le boîtier d'appareillage électronique est équipé d'ouies permettant la circulation dans le canal d'un fluide caloporteur provenant de l'extérieur du boîtier d'appareillage électronique.

Avantageusement, le dispositif est caractérisé en ce qu'il comporte des moyens pour assurer l'étanchéité du canal par rapport à l'espace intérieur utile du boîtier d'appareillage électronique.

L'invention sera mieux comprise par la description, donnée à titre d'exemple, de différentes réalisations du dispositif électronique selon l'invention, en référence aux dessins annexés dans lesquels :
- la figure 1 représente, une vue éclatée d'un sous-ensemble électronique du dispositif électronique selon l'invention comportant une carte de circuits imprimés, un radiateur, un capot et des joints déformables ;
- la figure 2a représente, dans une vue perspective un boîtier d'appareillage électronique pouvant héberger un sous-ensemble électronique ;
- la figure 2b représente, dans une vue perspective écorchée, la structure interne de la cavité constituée par le boîtier d'appareillage électronique présenté sur la figure 2a ;
- la figure 3 représente, dans une vue perspective écorchée, un dispositif électronique selon l'invention comportant un sous-ensemble électronique tel que représenté sur la figure 1 et un boîtier d'appareillage électronique tel que représenté sur la figure 2b et explicite le moyen par lequel le sous-ensemble électronique se loge dans le boîtier;
- la figure 4 représente, en coupe, un détail de la structure interne d'un ,dispositif électronique selon l'invention ;
- la figure 5 représente, en coupe, un dispositif électronique selon l'invention comportant un boîtier d'appareillage électronique et plusieurs sous-ensembles électroniques ;

Pour faciliter la lecture de la description, les mêmes repères désigneront les mêmes éléments dans les différentes figures.

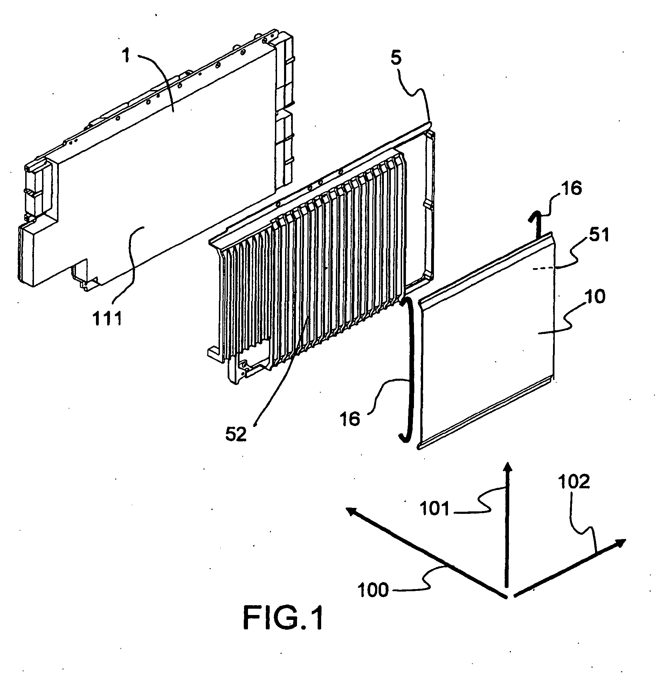

La figure 1, représente sur une vue éclatée, un dispositif électronique selon l'invention comportant une carte de circuits imprimés 1, un radiateur 5, un capot 10 et des joints déformables 16.

La carte de circuit imprimés 1, supporte des composants électroniques dissipant de la chaleur lorsqu'ils sont alimentés et en fonctionnement. Préférentiellement, les composants électroniques dissipant le plus de chaleur sont rassemblés sur une première face 111, de la carte de circuits imprimés 1.

Avantageusement, le radiateur 5, est sensiblement plan, parallèlement à la carte de circuits imprimés 1.

Une première face 51, du radiateur 5, est conformée pour être placée en contact avec des composants électroniques de la première face 111, de la carte de circuits imprimés 1, suivant un axe horizontal 100. Une deuxième face 52, du radiateur 5, est conformée pour évacuer la chaleur par convection. La deuxième face 52, comporte, par exemple, des ailettes dont la dimension suivant un axe vertical 101, correspond à la dimension verticale de la carte 1.

Avantageusement, le capot 10, est sensiblement plan, parallèlement à la carte de circuits imprimés 1.

Le capot 10 est conformé pour être appliqué contre le radiateur 5, suivant l'axe horizontal 100.

Les joints déformables 16, sont de forme linéaire, et sont fixés au radiateur 5, ou au capot 10. Ils maintiennent un espace libre entre la deuxième face 52 du radiateur 5, et le capot 10.

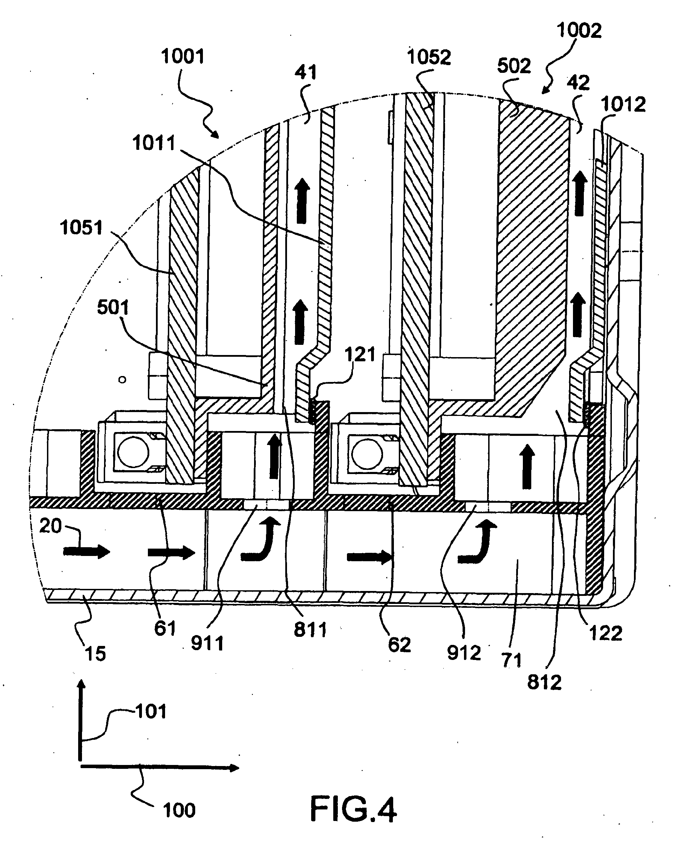

Lorsque la carte de circuits imprimés 1, le radiateur 5, les joints déformables 16, et le capot 10, sont assemblés entre eux suivant l'axe 100 pour former un ensemble solidaire, ils constituent un sous-ensemble électronique 1000. Dans ce cas, la deuxième face 52, du radiateur 5, et le capot 10 délimitent un canal 4, étanche, représenté plus explicitement sur la figure 4, dans lequel peut circuler suivant l'axe vertical, 101, un fluide caloporteur 20, assurant la convection de la chaleur dissipée par le radiateur 5.

Le fluide caloporteur 20, est par exemple de l'air pulsé porteur, éventuellement, d'impuretés corrosives.

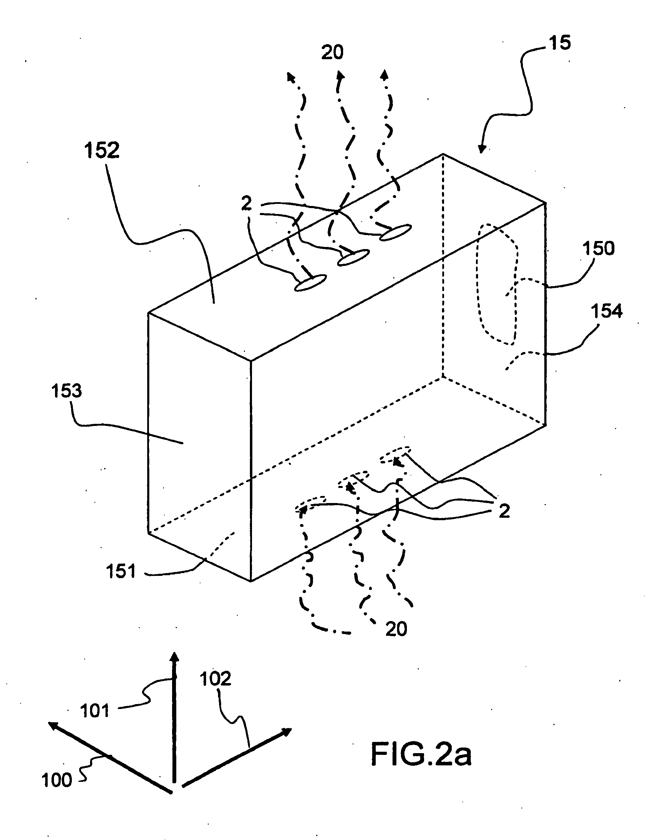

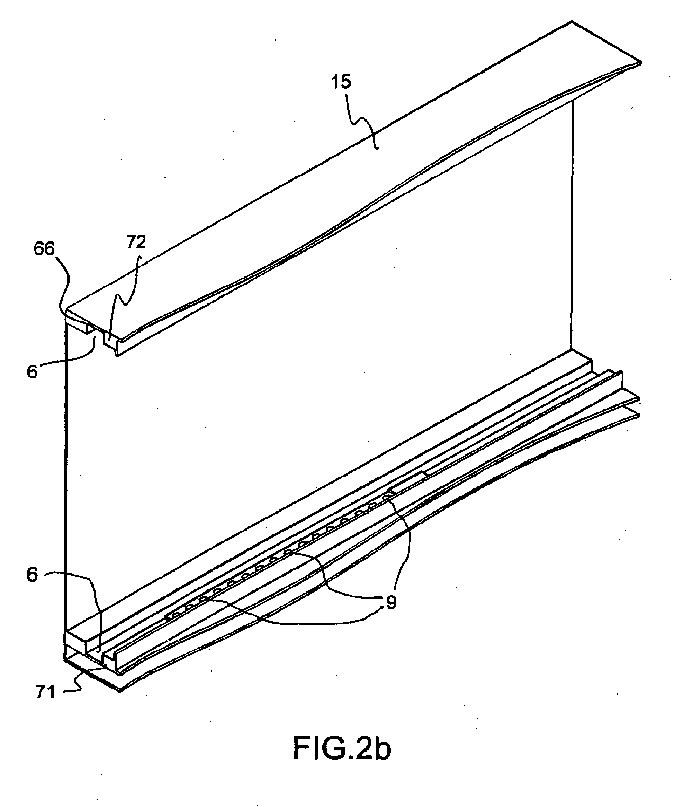

La figure 2a représente, sur une vue perspective, un boîtier d'appareillage électronique 15 selon l'invention. L'axe horizontal 100 et l'axe vertical 101 sont communs aux figures 2a et 2b.

Le boîtier 15, est métallique, de forme parallélépipédique et détimite une cavité interne. Des faces horizontales 151, 152 du boîtier 15, comportent des ouies 2, qui sont des orifices débouchants mettant en relation l'intérieur et l'extérieur du boîtier. Une face 153, du boîtier 15, ests amovible, elle peut être temporairement retirée pour introduire à l'intérieur de la cavité formée par le boîtier 15, au moins un sous-ensemble électronique 1000, semblable à celui de la figure 1, suivant un axe horizontal 102. Une face 154, du boîtier 15, est équipée d'au moins un connecteur 150, destiné à être raccordé avec un connecteur complémentaire.

Le connecteur complémentaire est monté sur un fond de panier d'un châssis, pour assurer les raccordements électriques des appareillages électroniques du boîtier 15, avec l'environnement extérieur dans lequel ils sont destinés à fonctionner.

Un boîtier équipé d'un tel connecteur 150 est « rackable » car il peut être placé avec d'autres dans un meuble de rangement d'appareillages électroniques à dimensions normalisées.

Ce type de boîtier 15, est couramment utilisé en aéronautique, par exemple pour réaliser des calculateurs de bord. Lorsque la face 154, amovible clôt le boîtier 15, le boîtier 15, est étanche au fluide caloporteur 20, dans lequel il baigne, hormis les ouies 2.

Avantageusement, le boîtier d'appareillage électronique 15 est enfichable et peut être monté, avec d'autres, de manière amovible sur un châssis.

La figure 2b représente partiellement, sur une vue perspective écorchée, un boîtier d'appareillage électronique 15, selon l'invention. Le boîtier 15, comporte, sur des parois internes des faces horizontales 151, 152, un moyen de verrouillage et des glissières 6. Le moyen de verrouillage, non représenté, sert à solidariser le sous-ensemble 1000, au boîtier 15. Les glissières 6, servent à guider le sous-ensemble électronique 1000, à l'intérieur du boîtier 15. Les glissières 6, comportent des orifices débouchants 9, mettant en relation l'espace intérieur au boîtier 15, avec des veines de circulation de fluide 71 et 72. Les veines 71, 72 sont, elles mêmes, mises en relation avec l'extérieur du boîtier 15, grâce aux ouies 2, placées sur la surface du boîtier 15, et débouchant dans les veines 71, 72. Les ouies sont visibles sur la figure 2a et ne sont pas représentées sur la figure 2b. Hormis les orifices débouchants 9, et les ouies 2, les veines 71, 72 sont étanches.

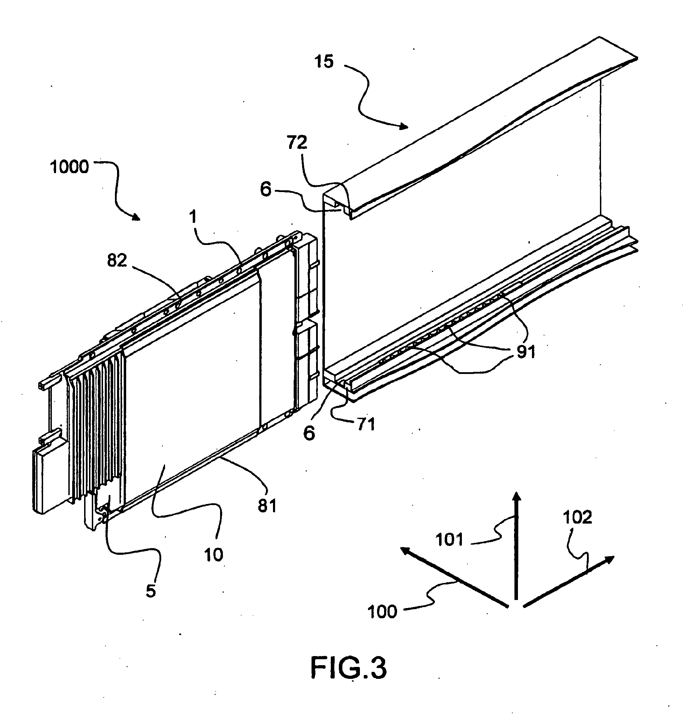

La figure 3 représente, sur une vue perspective, un dispositif électronique selon l'invention, comportant un sous-ensemble 1000 identique à celui présenté sur la figure 1, et un boîtier d'appareillage électronique 15, identique à celui présenté sur la figure 2b. Le sous-ensemble 1000 comporte une carte de circuits imprimés 1, un radiateur 5, des joints déformables 16 non visibles sur la figure 3, et un capot 10.

Le capot 10, et la deuxième face 52 du radiateur 5, délimitent un canal étanche 4, visible sur la figure 4. Le canal 4 possède deux extrémités 81, 82 situées, dans la représentation de la figure 3, respectivement sur les parties inférieures et supérieures du sous-ensemble 1000.

Le boîtier 15 est représenté partiellement pour faire apparaître la façon dont le sous-ensemble 1000, se loge dans le boîtier 15. Le sous-ensemble 100, guidé par les glissières 6, peut prendre, dans le boîtier 15, une position, appelée position de verrouillage, dans laquelle un moyen de verrouillage permet de le solidariser au boîtier 15. Une fois dans la position de verrouillage, le sous-ensemble électronique 1000 est complètement inséré à l'intérieur du boîtier 15, ce qui permet d'enfermer le sous-ensemble dans le boîtier 15, en replaçant la face 153 du boîtier 15, pour le clore.

Lorsque le sous-ensemble 1000, logeant dans le boîtier 15, est en position de verrouillage, les orifices débouchants 9, et les extrémités 81, 82, du canal 4, sont parfaitement juxtaposés. Ainsi, un fluide caloporteur 20, baignant l'extérieur du boîtier 15, comportant toutes ses faces, peut pénétrer à l'intérieur du boîtier 15, exclusivement par les ouies 2. Il emprunte ensuite les veines de circulation 71, 72, pour atteindre les orifices débouchants 9, pénétrer dans le canal 4, et lécher la deuxième face 52 du radiateur 5, en évitant tout contact avec les composants électroniques portés par la carte de circuits imprimés 1.

La figure 4 représente un détail du contact entre des sous-ensembles électroniques 1001, 1002 semblables à ceux de la figure 1 et un boîtier 15, semblable à celui de la figure 2b, sur une vue partielle, en coupe suivant un plan orthogonal à celui des cartes de circuits imprimés des sous-ensembles ou encore suivant le plan formé par 100 et 101.

Les deux sous-ensembles électroniques 1001, 1002, sont placés en position de verrouillage, parallèlement l'un à l'autre, dans le boîtier 15. Chacun des sous-ensembles 1001, 1002, est guidé par une glissière 61, 62 et solidarisé au boîtier 15, par un moyen de verrouillage qui n'est pas représenté. Chaque sous-ensemble 1001, 1002, comporte une carte de circuits imprimés 1051, 1052, un radiateur 501, 502, des joints déformables qui ne sont pas représentés sur cette figure, identiques à ceux représentés sur la figure 1 et un capot 1011, 1012. Pour chaque sous-ensemble électronique 1001, 1002, un canal étanche 41, 42, est formé entre le radiateur 501, 502, et le capot 1011, 1012 qui le composent.

Une extrémité 811, 812, du canal constitue une entrée pour un fluide caloporteur 20, venant de l'extérieur du boîtier 15, une autre extrémité, 821, 822, non représentée, constitue une sortie pour le fluide caloporteur 20. Les extrémités 811 et 812 débouchent sur des orifices 9, placées sur une paroi d'une veine de circulation de fluide 71, interne au boîtier 15. La paroi de la veine 71 comporte en outre des ouies 2, qui sont des orifices débouchants sur l'extérieur du boîtier 15, et qui ne sont pas représentés sur cette figure. Le nombre et la taille des orifices débouchants 9, sont adaptés à chaque canal 41, 42 pour correspondre au besoin de dissipation par convection du radiateur correspondant 51, 52. Le nombre et la taille des ouies 2, sont adaptés pour correspondre au besoin global de dissipation par convection des radiateurs des sous-ensembles électroniques enfermés dans le boîtier 15.

La connexion entre le canal 41, 42, et les veines de circulation de fluide 71, 72 est étanche. L'étanchéité est assurée d'une part grâce au moyen de verrouillage, d'autre part, grâce à des joints déformables étanches 121 et 122 placés entre le sous-ensemble électronique et la structure interne du boîtier 15.

Un fluide caloporteur 20, extérieur au boîtier 15 pénètre dans le boîtier 15 par les ouies 2, placées sur une paroi commune du boîtier 15 et de la veine 71. Il est transporté par la veine 71 jusqu'à des orifices débouchants 9, qui donnent accès à l'extrémité 811, 812 du canal étanche 41, 42. Le fluide caloporteur 20 traverse ensuite le canal étanche 41, 42 jusqu'à atteindre l'autre extrémité 821, 822, non représentée, du canal 41, 42 par les orifices débouchants 921, 922, également non représentés, qui donnent accès à la veine 72, toujours non représentée. Le fluide caloporteur 20, traverse enfin la veine 72 et sort du boîtier 15 par les ouies 2, placées sur une paroi commune du boîtier 15 et de la veine 72.

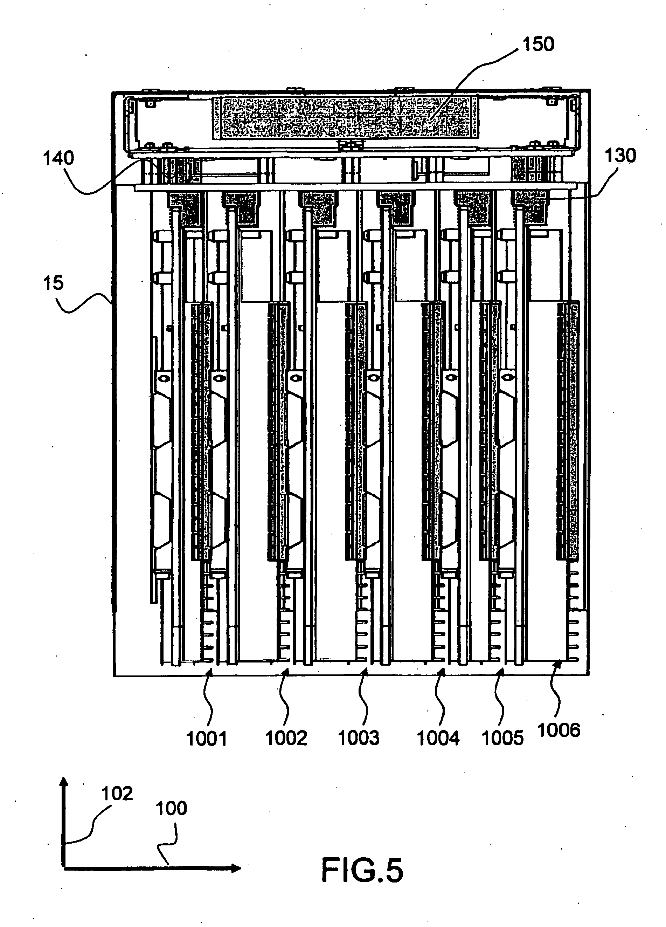

La figure 5 représente un dispositif électronique selon l'invention comprenant un boîtier d'appareillage électronique 15 et six sous-ensembles électroniques 1001, 1002, 1003, 1004, 1005, 1006, semblables à ceux de la figure 1, logés dans le boîtier 15, dans leur position de verrouillage, sur une vue en coupe suivant un plan orthogonal aux cartes de circuits imprimés des sous-ensembles, ou encore suivant le plan formé par 100 et 102.

Le boîtier 15 comporte des connecteurs internes 130, dans lesquels s'enfichent des sous-ensembles électroniques 1000. Les connecteurs internes 130, sont portés par un module d'interconnexion 140 comportant des contacts électriques, chaque contact comportant deux extrémités. Une des extrémités des contacts se connecte au connecteur 150, du boîtier 15. L'autre extrémité des contacts se connecte aux contacts de la carte du circuit imprimé.

Autrement dit, la carte de circuit imprimé 1 s'enfiche dans le boîtier d'appareillage électronique 15.

Avantageusement, le boîtier d'appareillage électronique 15 et la carte de circuits imprimés 1, logeant dans le boîtier d'appareillage électronique 15 répondent à une spécification appartenant à la liste suivante : ARINC 600, MIL 83 527, ARINC 404A.

## Revendications

1. Dispositif electronique comportant un boîtier d'appareillage electronique (15) logeant une pluralité de sous-ensembles électroniques (1000) entichés, chaque sous-ensemble électronique comprenant
- une carte de circuits imprimés (1) supportant des composants électroniques dissipant de la chaleur,
- un radiateur (5) dont une première face (5) est en contact avec des composants électroniques d'une première face (111) de la carte de circuits imprimés (1) et dont une deuxième face (52) est conformée pour évacuer la chaleur par convection,
**caractérisé en ce que** chaque sous-ensemble comporte également :
- un capot (10) solidaire du radiateur (5) et de la carte de circuits imprimés (1), délimitant un canal (4) entre la deuxième face (52) du radiateur (5) et le capot (10), pour la circulation d'un fluide caloporteur assurant la convection, des joints déformables (16) assurant l'étenchéité du canal (4),
le canal (4) de chaque sous-ensemble (1001) entiché dans le boitier évitant au fluide caloporteur (20) d'être en contact avec les composants électroniques.

2. Dispositif selon la revendcation 1, **caractérisé en ce que** ledit boîtier d'appereillage électronique (15), dans lequel se logent les sous-ensembles électroniques (1000), est équipé d'ouies (2) permettant la circulation dans le canal (41, 42) de chaque sous-ensemble d'un fluide caloporteur (1001, 1002) provenant de l'extérieur dudit boîtier (15).

3. Dispositif selon l'une des revendications précédentes, **caractérisé en ce que** le radiateur (5) d'un sous-ensemble électronique est sensiblement plan, parallèlement à la carte de circuits imprimés (1).

4. Dispostif selon l'une des revendications précédentes, **caractérisé en ce que** le capot (10) d'un sous-ensemble électronique est sensiblement plan, parallèlement à la carte de circuits imprimés (1).

5. Dispositif selon l'une des revendications précédentes, **caractérisé en ce qu'**il comporte des moyens pour assurer l'étanchéité de chaque canal (4) par rapport à l'espace intérieur utile du boîtier d'appareillage électronique (15).

6. Dispositif selon l'une des revendications précédentes, **caractérisé en ce que** le boîtier d'appareillage électronique (15) et les cartes de circuits imprimés (1) répondent à une spécification appartenant à la liste suivante : ARINC 600, MIL 83 527, ARINC 404A.

## Patentansprüche

1. Elektronische Vorrichtung, die ein elektronisches Gerätegehäuse (15) umfasst, das mehrere elektronische Einsteckbaugruppen (1000) aufnimmt, wobei jede elektronische Baugruppe Folgendes umfasst:
- eine Schaltungskarte (1), die wärmeabführende elektronische Komponenten trägt,
- einen Kühlkörper (5), dessen erste Fläche (5) mit elektronischen Komponenten einer ersten Fläche (111) der Schaltungskarte (1) in Kontakt ist und deren zweite Fläche (52) so geformt ist, dass die Wärme durch Konvektion abgeführt wird, **dadurch gekennzeichnet, dass** jede Baugruppe auch Folgendes umfasst:
- eine Abdeckkappe (10) einstückig mit dem Kühlkörper (5) und der Schaltungskarte (1), die einen Kanal (4) zwischen der zweiten Fläche (52) des Kühlkörpers (5) und der Abdeckkappe (10) begrenzt, zum Zirkulieren eines Wärmeaustauschfluids, das die Konvektion gewährleistet, verformbare Dichtungen (16), die die Dichtigkeit des Kanals (4) gewährleisten,
wobei der Kanal (4) jeder in das Gehäuse eingesteckten Baugruppe (1001) verhindert, dass Wärmeaustauschfluid (20) mit den elektronischen Komponenten in Kontakt kommt.

2. Vorrichtung nach Anspruch 1, **dadurch gekennzeichnet, dass** das elektronische Vorrichtungsgehäuse (15), in dem die elektronischen Baugruppen (1000) aufgenommen sind, mit Schlitzen (2) ausgestattet ist, die die Zirkulation eines von der Außenseite des Gehäuses (15) kommenden Wärmeaustauschfluids (1001, 1002) in dem Kanal (41, 42) jeder Baugruppe zulassen.

3. Vorrichtung nach einem der vorherigen Ansprüche, **dadurch gekennzeichnet, dass** der Kühlkörper (5) einer elektronischen Baugruppe im Wesentlichen eben und parallel zu der Schaltungskarte (1) ist.

4. Vorrichtung nach einem der vorherigen Ansprüche, **dadurch gekennzeichnet, dass** die Abdeckkappe (10) einer elektronischen Baugruppe im Wesentlichen eben und parallel zu der Schaltungskarte (1) ist.

5. Vorrichtung nach einem der vorherigen Ansprüche, **dadurch gekennzeichnet, dass** sie Mittel zum Gewährleisten der Dichtigkeit jedes Kanals (4) in Bezug auf den nützlichen Innenraum des elektronischen Vorrichtungsgehäuses (15) umfasst.

6. Vorrichtung nach einem der vorherigen Ansprüche, **dadurch gekennzeichnet, dass** das elektronische Gerätegehäuse (15) und die Schaltungskarten (1) einer Spezifikation aus der folgenden Liste entsprechen: ARINC 600, MIL 83 527, ARINC 404A.

## Claims

1. An electronic device comprising an electronic equipment unit (15) housing a plurality of plugged-in electronic sub-assemblies (1000), each electronic sub-assembly comprising:
- a printed circuit board (1) supporting heat dissipating electronic components;
- a heat sink (5), a first face (5) of which is in contact with electronic components on a first face (111) of said printed circuit board (1) and a second face (52) of which is designed to discharge heat by convection,
**characterised in that** each sub-assembly further comprises:
- a cover (10) integral with said heat sink (5) and said printed circuit board (1), delimiting a channel (4) between said second face (52) of said heat sink (5) and said cover (10) for circulating a heat transfer fluid providing the convection, deformable seals (16) sealing said channel (4),
said channel (4) of each sub-assembly (1001) plugged into said unit preventing heat transfer fluid (20) from coming into contact with said electronic components.

2. The device according to claim 1, **characterised in that** said electronic equipment unit (15), which houses said electronic sub-assemblies (1000), is provided with openings (2) allowing a heat transfer fluid (1001, 1002) from outside of said unit (15) to be circulated in the channel (41, 42) of each sub-assembly.

3. The device according to any one of the preceding claims, **characterised in that** said heat sink (5) of an electronic sub-assembly is essentially flat, parallel to said printed circuit board (1).

4. The device according to any one of the preceding claims, **characterised in that** said cover (10) of an electronic sub-assembly is essentially flat, parallel to said printed circuit board (1).

5. The device according to any one of the preceding claims, **characterised in that** it comprises means for sealing each channel (4) relative to the useful internal space of said electronic equipment unit (15).

6. The device according to any one of the preceding claims, **characterised in that** said electronic equipment unit (15) and said printed circuit board(s) (1) comply with a specification that belongs to the following list: ARINC 600, MIL 83 527, ARINC 404A.
